# EUROPÄISCHE PATENTSCHRIFT

(11) **EP 1 028 388 B1**
(45) Veröffentlichungstag und Bekanntmachung des Hinweises auf die Patenterteilung: **31.05.2006**
(21) Anmeldenummer: 00100695.6
(22) Anmeldetag: 14.01.2000
(51) Int. Cl.: G06K 19/077

(54) **Identifizierungselement und Verfahren zur Herstellung eines Identifizierungselements**
Identification element and method of manufacturing an identification element
Elément d'identification et procédé de fabrication d'un élément d'identification

(30) Priorität: 11.02.1999 DE 19905886
(43) Veröffentlichungstag der Anmeldung: 16.08.2000
(73) Patentinhaber: Meto International GmbH, 69434 Hirschhorn/Neckar (DE)
(72) Erfinder: Altwasser, Richard, 76689 Neuthard (DE)
(74) Vertreter: Menges, Rolf

(56) Entgegenhaltungen:
- EP-A- 0 665 705
- EP-A- 0 737 935
- FR-A- 2 753 819

## Beschreibung

Die Erfindung betrifft ein Identifizierungselement, bestehend aus einem integrierten Schaltkreis mit Kontakten und einer Antennenspule (→ RF/ID Transponder), wobei die Antennenspule aus zumindest einer Leiterbahn mit zumindest einer Windung besteht, wobei die Antennenspule mit dem integrierten Schaltkreis elektrisch verbunden ist und wobei der integrierte Schaltkreis und die Antennenspule auf einer Trägerschicht angeordnet sind. Desweiteren betrifft die Erfindung ein Verfahren zur Herstellung eines derartigen Identifzierungselements.

Der Vorteil von RFID-Transpondem gegenüber den insbesondere im Bereich der Warenkennzeichnung vornehmlich eingesetzten Barcodes besteht darin, daß sie einen direkten Austausch von Informationen erlauben, d. h. es ist kein Sichtkontakt für die Informationsübermittlung zwischen Abfragevorrichtung und Transponder erforderlich. Darüber hinaus ist es bei RFID-Transpondem im Gegensatz zu Barcodes problemlos möglich, deren Informationsinhalt bei Bedarf unmittelbar zu ändem.

RFID-Transponder kommen in den unterschiedlichsten Bereichen zur Anwendung. Sie lassen sich beispielsweise bei der Herstellung, der Weiterverarbeitung, dem Transport und der Sicherung von Waren wie auch bei der Personenkontrolle und der Kennzeichnung von Tieren einsetzen.

Der Nachteil der bekannten RFID-Transponder gegenüber Barcodes besteht in einem eklatanten Preisunterschied beider Kennzeichnungen. Dies ist auch der Grund dafür, daß RFID-Transponder bis heute auf dem Verkaufssektor nur in Randbereichen eingesetzt werden. Insbesondere wurde bislang von einer Bereitstellung von Preisinformation oder sonstiger Information mittels RFID-Transpondern bei Massenartikeln in Kaufhäusern und Lagern wegen der relativ hohen Kosten Abstand genommen.

Ein Verfahren zur Kontaktierung eines integrierten Schaltkreises mit einem Resonanzschwingkreis, der auf einem flexiblen Träger angebracht ist, und ein entsprechender Transponder werden in der EP 0 821 406 A1 beschrieben. Der Resonanzschwingkreis wird aus zwei elektrisch leitfähigen Mustern gebildet, die zu beiden Seiten des flexiblen Trägers angeordnet sind. Der Resonanzschwingkreis besitzt eine vorgegebene Induktivität und eine vorgegebene Kapazität.
Um eine gute Kontaktierung des integrierten Schaltkreises mit dem Resonanzschwingkreis zu gewährleisten, wird der Kontaktierungsbereich auf dem flexiblen Träger zuerst gereinigt. Anschließend wird der integrierte Schaltkreis über eine aus der Halbleitertechnik bekannte sog. Drahtverbindung (Wire-Bonding) mit dem Resonanzschwingkreis verbunden. Um zu verhindern, daß die Kontaktierung durch äußere Einwirkung wieder zerstört wird, werden der integrierte Schaltkreis und der Kontaktierungsbereich mit einer Schutzschicht überzogen.

Nachteilig bei diesem bekannten Verfahren bzw. dem bekannten Transponder sind einmal die relativ hohen Fertigungskosten. Hierzu trägt auch bei, daß der Schaltkreis und insbesondere der Kontaktierungsbereich zwischen Schaltkreis und Resonanzschwingkreis unbedingt nachträglich mit einer Schutzschicht überzogen werden, da ansonsten die Gefahr besteht, daß die Kontaktierung bei Gebrauch zerstört wird.
Für viele Anwendungsfälle ist es unbedingt erforderlich, daß die Transponder sich problemlos in Etiketten integrieren lassen. Da der Transponder der bekannten Lösung im Bereich des Chips wesentlich dicker ist als in den übrigen Bereichen, führt dies zu erheblichen Problemen beim Bedrucken in einem Etikettendrucker. Ein weiterer Nachteil der bekannten Lösung ist darin zu sehen, daß die den Resonanzschwingkreis bildenden Leiterbahnen durch Etchen hergestellt werden. Etchen ist ein relativ teueres Verfahren, das darüber hinaus auch in hohem Maße die Umwelt belastet.

Aus der EP 0 595 549 B1 ist ein femablesbarer Identifizierungsanhänger bekannt geworden, bei dem der elektrische Kontakt zwischen dem Chip und der Antenne mittels eines elektrisch leitenden Klebstoffs hergestellt wird (→ Flip-Chip-Bonding). Bei dieser Art der Kontaktierung kommen isotrope und anisotrope elektrisch leitfähige Klebesubstanzen zur Anwendung. Hierzu wird die elektrisch leitfähige Klebsubstanz in dem Kontaktbereich auf die Antenne aufgebracht. Die Kontaktbereiche des Chips werden in den elektrisch leitenden Klebstoff eingedrückt; anschließend wird der Klebstoff durch Wärmezufuhr ausgehärtet.

Problematisch hierbei ist, daß der elektrisch leitende Klebstoff entsprechend dosiert und lokal definiert auf die Antennenstruktur aufgebracht werden muß. Die Applikation erfolgt üblicherweise im Siebdruckverfahren, was insofern nachteilig ist, daß immer Reste des teueren elektrisch leitfähigen Klebers als Rückstände in den Applikationssieben verbleiben.
Auch wird für das Aushärten der Klebstoffe eine bestimmte Energiemenge benötigt. Da aber für die Wärmebehandlung nur begrenzte maximale Temperaturen angewendet werden dürfen, wirkt sich dies negativ auf die Taktzeit aus, die für die Aushärtung der Klebesubstanzen erforderlich ist. Die Folge hiervon sind wiederum die unerwünscht hohen Fertigungskosten.

Gemäß einer Variante des Flip-Chip-Bonding werden Klebstoffe verwendet, in denen elektrisch leitende Partikel willkürlich in so geringer Konzentration verteilt sind, daß der Klebstoff an sich nicht leitfähig ist (→ anisotrope Klebstoffe). Als elektrisch leitfähige Partikel werden Edelmetalle, wie z. B. Palladium, Silber oder Gold eingesetzt. Es sind aber auch mit Gold oder Nickel beschichtete Kunststoffkügelchen bekannt. Diese verfügen wegen der relativ großen zur Verfügung stehenden Oberfläche und der elastischen Eigenschaften des verwendeten Kunststoffmaterials über günstige Verbindungseigenschaften, da einerseits eine entsprechend große Kontaktoberfläche zur Verfügung steht und da andererseits die elastischen Rückstellkräfte dazu führen, daß zwischen Leiterbahn und Oberfläche der Kontaktstellen eine innige Berührung zustande kommt. Sind auch die Chipkontaktstellen aus einem Edelmetall, z. B. Gold, gefertigt und werden die Chipkontaktstellen anschließend über die Klebesubstanz auf die Antenne gedrückt, so befinden sich natürlich auch solche elektrisch leitenden und in dem Klebstoff verteilten Partikel zwischen den jeweils zu kontaktierenden Stellen von Chip und Antenne und sorgen für die beabsichtigte elektrische Verbindung. Unbestreitbarer Nachteil des Flip-Chip-Bonding sind die relativ teueren Klebesubstanzen.
Ein insbesondere bei der Verwendung von Aluminium als Material für die Antennenspule auftretendes Problem ist die Oxidschicht, die sich an der Oberfläche der Leiterbahnen ausbildet, sobald diese mit dem Sauerstoff der Luft in Kontakt kommen. Aluminiumoxid ist eine sehr harte Substanz und bekanntlich ein Isolator, was im Hinblick auf eine elektrische Kontaktierung natürlich in höchstem Maße störend ist.

Das Dokument EP 0 737 935 zeigt eine Vorrichtung und ein Verfahren gemäß den Oberbegriffen der unabhängigen Ansprüche 1 und 12.

Der Erfindung liegt die Aufgabe zugrunde, ein kostengünstiges Identifizierungselement sowie ein Verfahren zur Herstellung eines derartigen Identifizierungselements vorzuschlagen. Diese Aufgabe wird durch die Gegenstände der Ansprüche 1 und 12 gelöst.

Der klare Vorteil der erfindungsgemäßen Lösung gegenüber dem Stand der Technik, der elektrisch leitfähige Kleber zur Kontaktierung von integriertem Schaltkreis und Antennenspule vorschlägt, besteht darin, daß auf die teueren Klebesubstanzen mit den anisotrop oder isotrop verteilten leitfähigen Partikeln verzichtet werden kann. Die erfindungsgemäß zur Anwendung kommenden Kleber müssen lediglich die Anforderung erfüllen, daß sie beim Aushärten ihr Volumen verringern. Diese Anforderung ist bei vielen Klebern erfüllt, sobald sie eine Zustandsänderung flüssig →fest erfahren oder sobald sie von einer höheren Temperatur auf eine niedrige Temperatur abkühlen. Durch geeignete Wahl der Klebesubstanz und/oder der verwendeten Klebesubstanzmenge läßt sich die Stärke des Preßkontakts zwischen Bumps und Antennenspule definiert einstellen. Vorteilhaft, da sehr kostengünstig ist weiterhin, daß die Leiterbahn/ die Leiterbahnen der Antennenspule aus einer Metallfolie ausgestanzt ist/sind. Daher ist die erfindungsgemäße Lösung relativ kostengünstig. Ein Verfahren zur Herstellung von derartigen Leiterbahnen ist bereits aus der EP 0 665 705 A1 bekannt geworden. Das in dieser Offenlegungsschrift beschriebene Verfahren ist auch im Zusammenhang mit der Herstellung der Antennenspulen, die für das erfindungsgemäße Identifizierungselement zum Einsatz kommen, bevorzugt verwendbar.

Gemäß einer vorteilhaften Weiterbildung des erfindungsgemäßen Identifizierungselements wird vorgeschlagen, daß die Bumps im wesentlichen aus Palladium gefertigt sind. Palladium ist relativ kostengünstig und weist die erforderliche Härte auf.

Eine bevorzugte Ausgestaltung des erfindungsgemäßen Identifizierungselements sieht vor, daß die mit der Oberfläche der Antennenspule kontaktierte Oberfläche der Bumps eine Oberflächenrauhigkeit mit einer vorgegebenen Rauhtiefe aufweist. Die Rauhtiefe beträgt mindestens 5 µm. Der Vorzug dieser Ausgestaltung ist darin zu sehen, daß infolge der Oberflächenrauhigkeit zwischen Antennenspule und Bump befindliche Materialien, die die elektrische Kontaktierung behindern, aufgebrochen und infolge des Anpreßdruckes gegebenenfalls aus dem Kontaktierungsbereich verdrängt werden. Bei diesen störenden Materialien kann es sich beispielsweise um Verunreinigungen durch die Kontaktsubstanz handeln, die für den Anpreßdruck zwischen Antennenspule und integriertem Schaltkreis verantwortlich ist. Als weiteres Beispiel für störende Substanzen seien organische Schutzschichten auf der Leiterbahn genannt. Besonders störend ist es, wenn es sich bei der Zwischenschicht um eine Oxidschicht handelt. So bildet sich an der Oberfläche von Leiterbahnen aus Aluminium eine Oxidschicht, sobald diese mit dem Sauerstoff der Luft in Kontakt kommen. Aluminiumoxid ist eine sehr harte Substanz und bekanntlich ein Isolator, was im Hinblick auf eine elektrische Kontaktierung natürlich ein beträchtliches Problem aufwirft.

Um diese Aluminiumoxidschicht aufzubrechen und so die Funktionstüchtigkeit des erfindungsgemäßen Identifizierungselements sicherzustellen, ist die aufgerauhte Palladiumoberfläche der Bumps bestens geeignet. Die Struktur, die die Aufrauhung der Oberfläche der Bumps aufweist, ist im Grunde genommen beliebig. So kann sie beispielsweise als Randüberhöhung ausgestaltet sein. Sie kann aber genauso gut keil-, kegel- oder pyramidenförmig sein.

Gemäß einer vorteilhaften Weiterbildung des erfindungsgemäßen Identifizierungselements handelt es sich bei der Kontaktsubstanz um einen pastösen oder flüssigen Klebstoff oder um eine Klebefolie.

Günstig ist es weiterhin, wenn die Substanz so angeordnet ist, daß zumindest die Bereiche, in denen die Bumps mit der Antennenspule verbunden sind, gasdicht versiegelt sind. Hierdurch lassen sich atmosphärische Umwelteinflüsse weitgehend ausschließen.

Gemäß einer bevorzugten Ausführungsform des erfindungsgemäßen Identifizierungselements besteht die Antennenspule aus einer unteren Leiterbahn und einer oberen Leiterbahn, wobei die beiden Leiterbahnen so angeordnet sind, daß sie zumindest in ausgewählten Bereichen überlappen; weiterhin ist eine dielektrische Schicht vorgesehen, die zumindest in ausgewählten Bereichen zwischen den beiden Leiterbahnen angeordnet ist.

Eine vorteilhafte Weiterbildung des erfindungsgemäßen Identifizierungselements sieht vor, daß die beiden Leiterbahnen in einem Überlappungsbereich elektrisch miteinander kontaktiert sind. Weiterhin wird in einer weiteren Ausgestaltung vorgeschlagen, den integrierten Schaltkreis zwischen der unteren Leiterbahn und der oberen Leiterbahn zu kontaktieren.

Zur Erhöhung der Stabilität und der Widerstandsfähigkeit des erfindungsgemäßen Identifizierungselements schlägt eine vorteilhafte Ausführungsform eine Beschichtung vor, die die Oberfläche des Identifizierungselements oder zumindest Teile davon versiegelt. Bei der Beschichtung kann es sich beispielsweise um eine Schrumpffolie handeln. Möglich ist jedoch auch eine Lackbeschichtung.

Bezüglich des erfindungsgemäßen Verfahrens zur Herstellung des Identifizierungselements wird die Aufgabe dadurch gelöst, daß die Leiterbahn/die Leiterbahnen der Antennenspule aus einer Aluminiumfolie ausgestanzt wird/werden, daß an den Kontakten des integrierten Schaltkreises Anschlußpodeste, sog. Bumps, ausgebildet werden, die über die Grundfläche des integrierten Schaltkreises überstehen; zumindest im Bereich der Bumps wird eine Substanz aufgebracht, die infolge einer definierten Volumenverringerung beim Aushärten eine Druck- und/oder Zugkraft zwischen integriertem Schaltkreis und Trägerschicht erzeugt, wodurch die Bumps mit der Antennenspule über einen Preßkontakt verbunden werden.

Eine vorteilhafte Ausgestaltung des erfindungsgemäßen Verfahrens sieht vor, daß die Bumps im wesentlichen aus stromlos abgeschiedenem Palladium gefertigt werden. Weiterhin wird die mit der Antennenspule kontaktierte Oberfläche der Bumps aufgerauht. Vorzugsweise beträgt die Rauhtiefe mindestens 5 µm. In einem letzten optionalen Schritt wird das Identifizierungselement zumindest im Bereich des integrierten Schaltkreises mit einer Schutzfolie überzogen.

Die Erfindung wird anhand der nachfolgenden Figuren näher erläutert. Es zeigt:
Fig. 1: eine Draufsicht auf die untere Leiterbahn,
Fig. 2: eine Draufsicht auf die obere Leiterbahn,
Fig. 3: eine Draufsicht auf eine Ausgestaltung des erfindungsgemäßen Identifizierungselements und
Fig. 4: einen Querschnitt durch das Identifizierungselement im Bereich des integrierten Schaltkreises.

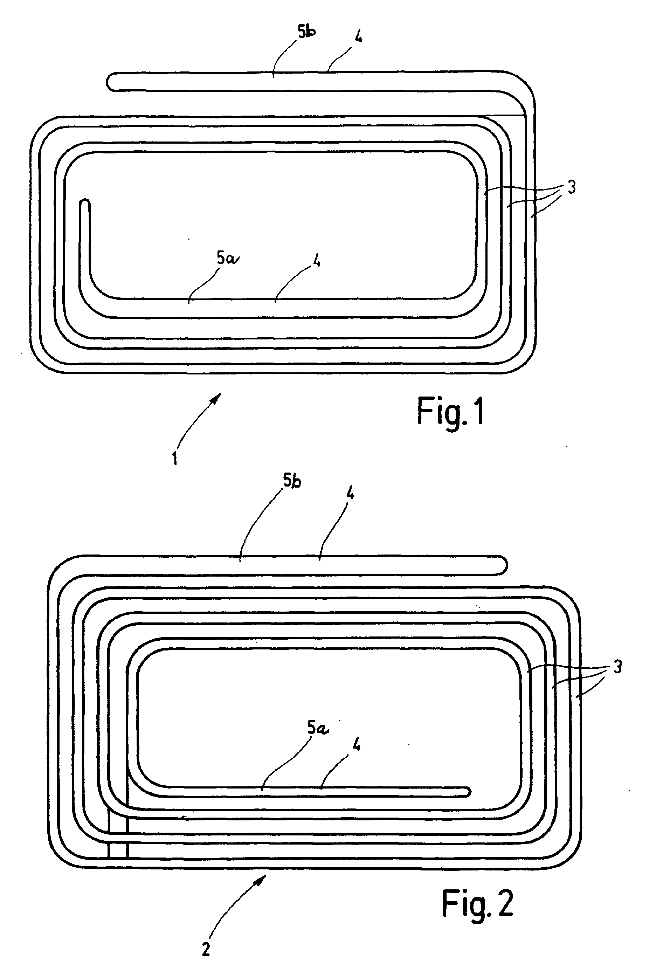

Fig. 1 zeigt eine Draufsicht auf die untere Leiterbahn 1 der Antennenspule 7. Während die untere Leiterbahn 1 nahezu drei Windungen 3 hat, weist die obere Leiterbahn 2 - wie aus der Draufsicht in Fig. 2 zu sehen ist - nahezu vier Windungen 3 auf. Folge der relativ hohen Windungszahl ist eine hohe Induktivität und letztlich die Bereitstellung einer ausreichend hohen induzierten Spannung zur Aktivierung des integrierten Schaltkreises 6. Die beiden Leiterbahnen 1, 2 sind übrigens entgegengesetzt gewickelt.

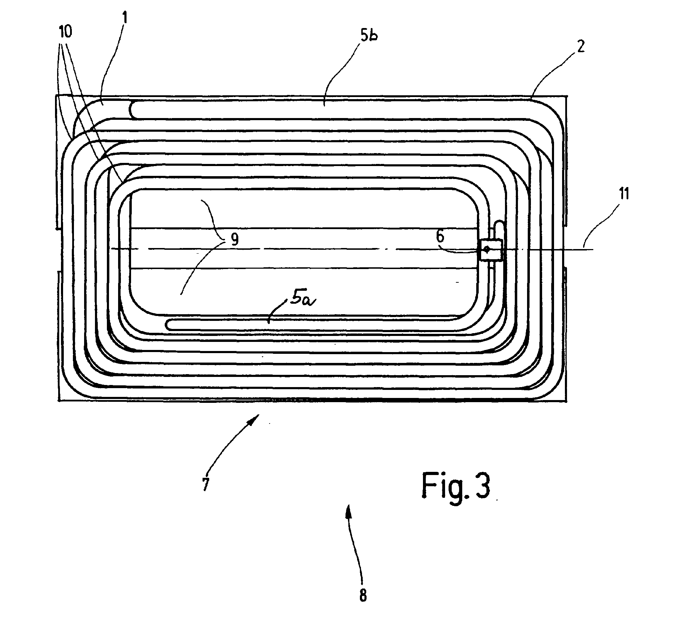

Fig. 3 zeigt übrigens das fertige Identifizierungselement 8, das aus den beiden Leiterbahnen 1, 2 zusammengesetzt ist.

Der Anfangsbereich 5a und der Endbereich 5b der unteren Leiterbahn 1 sowie der Endbereich 5b der oberen Leiterbahn 2 haben eine größere Breite als die übrigen Bereiche der Leiterbahnen 1, 2 . Die beiden Leiterbahnen 1, 2 sind aus einer Aluminiumfolie ausgestanzt.

Zwecks Bildung der Antennenspule 7 ist zwischen den beiden Leiterbahnen 1, 2 eine dielektrische Schicht 4 angeordnet. Die beiden Leiterbahnen 1, 2 sind derart zueinander positioniert, daß sie im wesentlichen nur in ausgewählten Bereichen 5a, 5b überlappen. Gemäß einer bevorzugten Ausgestaltung sind die beiden Leiterbahnen 1, 2 im Überlappungsbereich 5b der äußeren Windungen 3 elektrisch miteinander kontaktiert. Im einfachsten Fall erfolgt die Kontaktierung über ein Durchstanzen der beiden Leiterbahnen im Überlappungsbereich 5b. Andere Methoden der Kontaktierung sind jedoch ebenfalls anwendbar.

Bei der dielektrischen Schicht 4, die zwischen den beiden Leiterbahnen 1, 2 angeordnet ist, handelt es sich vorzugsweise um einen dielektrischen Heißkleber. Die dielektrische Schicht 4 isoliert die beiden Leiterbahnen 1, 2 elektrisch voneinander. Durch die versetzte Positionierung der beiden Leiterbahnen 1, 2 wird erreicht, daß der Hauptanteil der Kapazität aus den Überlappungsbereichen 5a herrührt, während die übrigen Überlappungsbereiche 10, in denen sich die beiden Leiterbahnen 1, 2 kreuzen, nur unwesentliche Beiträge zur Gesamtkapazität liefern. Durch diese Ausgestaltung wird die Kapazität und damit die Energie der Antennenspule 7 in dem Bereich konzentriert, in dem sie benötigt wird, nämlich in unmittelbarer Nachbarschaft zu dem Chip.

Der integrierte Schaltkreis 6, also der vorzugsweise unverpackte Chip 6, ist zwischen dem Endbereich der unteren Leiterbahn 1 und dem Endbereich der oberen Leiterbahn 2 in unmittelbarer Nähe der mittleren Achse 11 der Antennenspule 7 angeordnet.
Die Kontaktierung erfolgt zwischen Chip 6 und Leiterbahnen 1, 2.

Um zu verhindern, daß in den Überlappungsbereichen 10 ein Kurzschluß auftritt, der die Antennenspule 7 und damit das Identifizierungselement 8 deaktivieren würde, ist zumindest in diesen Bereichen 10 eine zusätzliche dielektrische Folie 9 oder eine sonstige zusätzliche dielektrische Schicht vorgesehen.

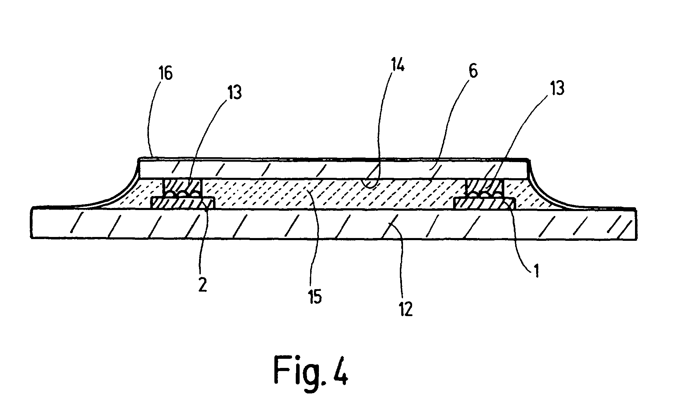

In Fig. 4 ist ein Querschnitt durch das Identifizierungselement 8 im Bereich des integrierten Schaltkreises 6 dargestellt. Der integrierte Schaltkreis 6 weist Bumps 13 auf, die über seine Grundfläche 14 überstehen.

Auf einer Trägerschicht 12, die z. B. aus PVC oder PET gefertigt ist, ist eine Leiterbahn 1; 2 ; 1, 2 aufgebracht. Die Leiterbahn 1, 2 ist - wie bereits an vorhergehender Stelle beschrieben - vorzugsweise aus einer Aluminiumfolie ausgestanzt. Im Bereich des integrierten Schaltkreises 6 ist zwischen Trägerschicht 12 und Grundfläche 14 des integrierten Schaltkreises 6 eine relativ dünne Schicht einer Kontaktsubstanz 15, z. B. eines Klebstoffs, aufgetragen. Diese Kontaktsubstanz 15 hat außer den üblichen Klebeeigenschaften auch die Eigenschaft, daß sie beim Aushärten eine definierte Volumenverringerung erfährt. Die Aushärtung kann durch Energiezufuhr beschleunigt werden. Infolge der Volumenverringerung der Kontaktsubstanz 15 wird eine innige und mit einer Vorspannung behaftete Zugkraft zwischen dem integrierten Schaltkreis 6 und der Trägerschicht 12 erreicht. Hierdurch werden die überstehenden Bumps 13 des integrierten Schaltkreises 6 an die Leiterbahn 1, 2 angepreßt.

Die mit der Leiterbahn 1, 2 in Kontakt kommende Oberfläche der Bumps 13 ist strukturiert. Hierdurch wird einerseits eine unerwünschte Schicht, die die elektrische Kontaktierung zwischen Schaltkreis 6 und Leiterbahn 1, 2 stört, aufgebrochen. Andererseits wird durch die Strukturierung der Kontaktfläche der Bumps 13 eine bessere Verzahnung und damit eine verbesserte elektrische Verbindung mit einem geringen Übergangswiderstand im Kontaktbereich erzielt. Erfindungsgemäß wird ein metallischer Kontakt mittels Kaltpreßschweißverbindung erreicht werden.

Die Struktur der Kontaktfläche der Bumps 13 kann sehr unterschiedlich ausgestaltet sein. Neben einer Randüberhöhung kann die Oberfläche auch eine Keil-, Kegel- oder Pyramidenform aufweisen.

### Bezugszeichenliste

- 1: untere Leiterbahn
- 2: obere Leiterbahn
- 3: Windung
- 4: dielektrische Schicht
- 5a: Überlappungsbereich / Endbereich
- 5b: Überlappungsbereich / Endbereich
- 6: integrierter Schaltkreis
- 7: Antennenspule
- 8: Identifizierungselement
- 9: dielektrische Folie
- 10: Überlappungsbereich
- 11: mittlere Achse
- 12: Trägerschicht
- 13: Bump
- 14: Grundfläche des integrierten Schaltkreises
- 15: Kontaktsubstanz
- 16: Beschichtung

## Patentansprüche

1. Identifzierungselement, bestehend aus einem integrierten Schaltkreis mit Kontakten und einer Antennenspule, wobei die Antennenspule aus zumindest einer Leiterbahn mit zumindest einer Windung besteht und wobei die Antennenspule mit dem integrierten Schaltkreis elektrisch verbunden ist, wobei der integrierte Schaltkreis und die Antennenspule auf einer Trägerschicht angeordnet sind, und wobei an den Kontakten des integrierten Schaltkreises (6) Anschlußpodeste (13), sog. Bumps (13), ausgebildet sind, die über die Grundfläche (14) des integrierten Schaltkreises (6) überstehen,
**dadurch gekennzeichnet,**
**daß** die Leiterbahn/Leiterbahnen (1, 2) der Antennenspule (7) aus einer Aluminiumfolie ausgestanzt ist/sind,
und
**daß** zwischen dem integrierten Schaltkreis (6) und der Trägerschicht (12) eine Substanz (15) vorgesehen ist, die infolge einer definierten Volumenverringerung beim Aushärten eine Druck- und/oder Zugkraft erzeugt, so daß die Bumps (13) mit der Antennenspule (7) über einen Preßkontakt verbunden sind.

2. Identifzierungselement nach Anspruch 1,
**dadurch gekennzeichnet,**
**daß** die Bumps (13) im wesentlichen aus Palladium gefertigt sind.

3. Identifizierungselement nach Anspruch 1 oder 2,
**dadurch gekennzeichnet,**
**daß** die mit der Oberfläche der Antennenspule (7) kontaktierte Oberfläche der Bumps (13) eine Oberflächenrauhigkeit mit einer vorgegebenen Rauhtiefe aufweist.

4. Identifzierungselement nach Anspruch 3,
**dadurch gekennzeichnet,**
**daß** die Oberfläche der Bumps (13) eine Rauhtiefe von mindestens 5 µm aufweist.

5. Identifzierungselement nach einem oder mehreren der vorhergehenden Ansprüche,
**dadurch gekennzeichnet,**
**daß** es sich bei der Substanz (15) um einen pastösen oder flüssigen Klebstoff oder um eine Folie handelt.

6. Identifzierungselement nach Anspruch 1 oder 5,
**dadurch gekennzeichnet,**
**daß** die Substanz (15) derart angeordnet ist, daß zumindest die Bereiche, in denen die Bumps (13) mit der Antennenspule (7) verbunden sind, gasdicht versiegelt sind.

7. Identifizierungselement nach Anspruch 1, 3 oder 6,
**dadurch gekennzeichnet,**
**daß** die Antennenspule (7) aus einer unteren Leiterbahn (1) und einer oberen Leiterbahn (2) besteht, wobei die beiden Leiterbahnen (1, 2) so angeordnet sind, daß sie zumindest in ausgewählten Bereichen (5a, 5b, 10) überlappen, und
**daß** eine dielektrische (4) Schicht vorgesehen ist, die zumindest in den ausgewählten Bereichen (5a, 5b, 10) zwischen den beiden Leiterbahnen (1, 2) angeordnet ist.

8. Identifizierungselement nach Anspruch 7,
**dadurch gekennzeichnet,**
**daß** die beiden Leiterbahnen (1, 2) mittels einer dielektrischen Klebeschicht miteinander verbunden sind.

9. Identifizierungselement nach Anspruch 7 oder 8,
**dadurch gekennzeichnet,**
**daß** die beiden Leiterbahnen (1, 2) in einem Überlappungsbereich (5b) elektrisch miteinander kontaktiert sind.

10. Identifizierungselement nach Anspruch 7, 8 oder 9,
**dadurch gekennzeichnet,**
**daß** der integrierte Schaltkreis (6) mit der unteren Leiterbahn (1) und der oberen Leiterbahn (2) kontaktiert ist.

11. Identifizierungselement nach einem oder mehreren der vorhergehenden Ansprüche,
**dadurch gekennzeichnet,**
**daß** eine Beschichtung (16) vorgesehen ist, die die Oberfläche des Identifizierungselements (8) oder zumindest Teile davon versiegelt.

12. Verfahren zur Herstellung eines Identifizierungselements, bestehend aus einem integrierten Schaltkreis mit Kontakten und einer Antennenspule, wobei
die Antennenspule aus zumindest einer Leiterbahn mit zumindest einer Windung besteht und wobei die Antennenspule mit dem integrierten Schaltkreis elektrisch verbunden ist, wobei der integrierte Schaltkreis und die Antennenspule auf einer Trägerschicht angeordnet sind, und wobei an den Kontakten des integrierten Schaltkreises (6) Anschlußpodeste (13), sog. Bumps (13), ausgebildet werden, die über die Grundfläche (14) des integrierten Schaltkreises (6) überstehen,
**dadurch gekennzeichnet,**
**daß** die Leiterbahn/Leiterbahnen (1, 2) der Antennenspule (7) aus einer Aluminiumfolie ausgestanzt wird/werden,
und
**daß** zumindest im Bereich der Bumps (13) eine Substanz (15) aufgebracht wird, die infolge einer definierten Volumenverringerung beim Aushärten eine Druck- und/oder Zugkraft zwischen integriertem Schaltkreis (6) und Trägerschicht (12) erzeugt, wodurch die Bumps (13) mit der Antennenspule (7) über einen Preßkontakt verbunden werden.

13. Verfahren nach Anspruch 12,
**dadurch gekennzeichnet,**
**daß** die Bumps (13) im wesentlichen aus stromlos abgeschiedenem Palladium gefertigt werden.

14. Verfahren nach Anspruch 12 oder 13,
**dadurch gekennzeichnet,**
**daß** die mit der Oberfläche der Antennenspule (7) kontaktierte Oberfläche der Bumps (13) aufgerauht wird, wobei die Rauhtiefe mindestens 5 µm aufweist.

15. Verfahren nach Anspruch 12, 13 oder 14,
**dadurch gekennzeichnet,**
**daß** das Identifizierungselement (8) zumindest im Bereich des integrierten Schaltkreises (6) mit einer Beschichtung (16) überzogen wird.

## Claims

1. An identification element comprising an integrated circuit with contacts and an antenna coil, wherein the antenna coil is comprised of at least one conducting track with at least one turn and wherein the antenna coil is electrically connected to the integrated circuit, wherein the integrated circuit and the antenna coil are arranged on a substrate, and wherein terminal pads (13) referred to as bumps (13) projecting from the undersurface (14) of the integrated circuit (6) are formed on the contacts of the integrated circuit (6),
**characterized in that** the conducting track/conducting tracks (1, 2) of the antenna coil (7) is/are die-stamped from aluminum foil, and
**that** between the integrated circuit (6) and the substrate (12) provision is made for a substance (15) which, as a result of a defined volume reduction occurring during curing, produces a compressive and/or tensile force whereby the bumps (13) are connected to the antenna coil (7) by a press contact.

2. The identification element as claimed in claim 1,
**characterized in that** the bumps (13) are essentially made of palladium.

3. The identification element as claimed in claim 1 or 2,
**characterized in that** the surface of the bumps (13) bonded to the surface of the antenna coil (7) has a predetermined surface roughness.

4. The identification element as claimed in claim 3,
**characterized in that** the surface of the bumps (13) has a roughness of at least 5 µm.

5. The identification element as claimed in one or several ones of the preceding claims,
**characterized in that** the substance (15) is a pasty or liquid adhesive or a foil.

6. The identification element as claimed in claim 1 or 5,
**characterized in that** the substance (15) is situated such that at least those areas in which the bumps (13) are connected with the antenna coil (7) are sealed gas-tight.

7. The identification element as claimed in claim 1, 3 or 6,
**characterized in that** the antenna coil (7) is comprised of a lower conducting track (1) and an upper conducting track (2), said two conducting tracks (1, 2) being arranged such as to overlap at least in selected areas (5a, 5b, 10),
and
**that** provision is made for a dielectric layer (4) that is disposed at least in said selected areas (5a, 5b, 10) between said two conducting tracks (1, 2).

8. The identification element as claimed in claim 7,
**characterized in that** the two conducting tracks (1, 2) are interconnected by means of a dielectric adhesive layer.

9. The identification element as claimed in claim 7 or 8,
**characterized in that** the two conducting tracks (1, 2) are electrically interconnected in an area of track overlap (5b).

10. The identification element as claimed in claim 7, 8 or 9,
**characterized in that** the integrated circuit (6) is bonded to the lower conducting track (1) and the upper conducting track (2).

11. The identification element as claimed in one or several ones of the preceding claims,
**characterized in that** provision is made for a coating (16) for sealing the surface of the identification element (8) or at least parts thereof.

12. A method of manufacturing an identification element comprising an integrated circuit with contacts and an antenna coil, wherein the antenna coil is comprised of at least one conducting track with at least one turn and wherein the antenna coil is electrically connected to the integrated circuit, wherein the integrated circuit and the antenna coil are arranged on a substrate, and wherein terminal pads (13) referred to as bumps (13) projecting from the undersurface (14) of the integrated circuit (6) are formed on the contacts of the integrated circuit (6),
**characterized by** the steps of
die-stamping the conducting track/conducting tracks (1, 2) of the antenna coil (7) from aluminum foil; and
applying at least in the area of the bumps (13) a substance (15) which, as a result of a defined volume reduction occurring during curing, produces a compressive and/or tensile force between the integrated circuit (6) and the substrate (12) whereby the bumps (13) are connected to the antenna coil (7) by a press contact.

13. The method as claimed in claim 12,
**characterized by** the step of
fabricating the bumps (13) essentially from palladium using a currentless deposition technique.

14. The method as claimed in claim 12 or 13,
**characterized by** the step of
roughening the surface of the bumps (13) bonded to the surface of the antenna coil (7) to a surface roughness of at least 5 µm.

15. The method as claimed in claim 12, 13 or 14,
**characterized by** the step of
applying a coating (16) to the identification element (8) at least in the area of the integrated circuit (6).

## Revendications

1. Élément d'identification, composé d'un circuit intégré comprenant des contacts ainsi que d'une bobine-antenne, la bobine-antenne se composant d'au moins une piste conductrice comprenant au moins une spire et la bobine-antenne étant reliée électriquement au circuit intégré, le circuit intégré et la bobine-antenne étant disposés sur une couche formant support, et des paliers de raccordement (13) - ce qu'il est convenu d'appeler des bosses ou "bumps" (13) - lesquels font saillie au-dessus de la surface de base (14) du circuit intégré (6), étant réalisés à l'endroit des contacts du circuit intégré (6),
**caractérisé en ce que**
la ou les pistes conductrices (1, 2) de la bobine-antenne (7) sont découpées à la matrice dans une feuille d'aluminium, et
**en ce qu**'il est prévu, entre le circuit intégré (6) et la couche formant support (12), une substance (15) qui, par suite d'une réduction définie de volume lorsqu'elle durcit, produit une force de pression et/ou de traction de sorte que les bosses (13) sont reliées à la bobine-antenne (7) par un contact à pression.

2. Élément d'identification selon la revendication 1,
**caractérisé en ce que**
les bosses (13) sont sensiblement fabriquées en palladium.

3. Élément d'identification selon la revendication 1 ou 2,
**caractérisé en ce que**
la surface des bosses (13) mise en contact avec la surface de la bobine-antenne (7) présente une rugosité superficielle ayant une profondeur de rugosité donnée.

4. Élément d'identification selon la revendication 3,
**caractérisé en ce que**
la surface des bosses (13) présente une profondeur de rugosité d'au moins 5 µm.

5. Élément d'identification selon une ou plusieurs des revendications précédentes,
**caractérisé en ce que**
la substance (15) est une colle pâteuse ou liquide ou une feuille.

6. Élément d'identification selon la revendication 1 ou 5,
**caractérisé en ce que**
la substance (15) est disposée de telle sorte qu'au moins les zones dans lesquelles les bosses (13) sont reliées à la bobine-antenne (7) sont scellées de manière étanche aux gaz.

7. Élément d'identification selon la revendication 1, 3 ou 6,
**caractérisé en ce que**
la bobine-antenne (7) se compose d'une piste conductrice inférieure (1) et d'une piste conductrice supérieure (2), les deux pistes conductrices (1, 2) étant disposées de manière qu'elles se chevauchent au moins dans des zones choisies (5a, 5b, 10), et
**en ce qu**'il est prévu une couche diélectrique (4) qui est disposée, au moins dans les zones choisies (5a, 5b, 10), entre les deux pistes conductrices (1, 2).

8. Élément d'identification selon la revendication 7,
**caractérisé en ce que**
les deux pistes conductrices (1, 2) sont reliées ensemble au moyen d'une couche adhésive diélectrique.

9. Élément d'identification selon la revendication 7 ou 8,
**caractérisé en ce que**
les deux pistes conductrices (1, 2) sont mutuellement mises en contact électrique dans une zone de recouvrement (5b).

10. Élément d'identification selon la revendication 7, 8 ou 9,
**caractérisé en ce que**
le circuit intégré (6) est mis en contact avec la piste conductrice inférieure (1) et la piste conductrice supérieure (2).

11. Élément d'identification selon une ou plusieurs des revendications précédentes,
**caractérisé en ce que**
il est prévu un revêtement (16) qui scelle la surface de l'élément d'identification (8) ou au moins certaines de ses parties.

12. Procédé de fabrication d'un élément d'identification composé d'un circuit intégré comprenant des contacts ainsi que d'une bobine-antenne, la bobine-antenne se composant d'au moins une piste conductrice comprenant au moins une spire et la bobine-antenne étant reliée électriquement au circuit intégré, le circuit intégré et la bobine-antenne étant disposés sur une couche formant support, et des paliers de raccordement (13) - ce qu'il est convenu d'appeler des bosses ou "bumps" (13) - lesquels font saillie au-dessus de la surface de base (14) du circuit intégré (6) étant réalisés à l'endroit des contacts du circuit intégré (6),
**caractérisé en ce que**
la ou les pistes conductrices (1, 2) de la bobine-antenne (7) sont découpées à la matrice dans une feuille d'aluminium, et
**en ce qu**'on applique, au moins dans la zone des bosses (13), une substance (15) qui, par suite d'une réduction définie de volume lorsqu'elle durcit, produit une force de pression et/ou de traction entre le circuit intégré (6) et la couche formant support (12), ce qui a pour effet de relier les bosses (13) à la bobine-antenne (7) par un contact à pression.

13. Procédé selon la revendication 12,
**caractérisé en ce que**
les bosses (13) sont sensiblement fabriquées en palladium séparé sans courant.

14. Procédé selon la revendication 12 ou 13,
**caractérisé en ce que**
la surface des bosses (13) mise en contact avec la surface de la bobine-antenne (7) est rendue rugueuse, la profondeur de rugosité étant d'au moins 5 µm.

15. Procédé selon la revendication 12, 13 ou 14,
**caractérisé en ce que**
l'élément d'identification (8) est recouvert, au moins dans la zone du circuit intégré (6), d'un revêtement (16).
